# EUROPEAN PATENT SPECIFICATION

(11) **EP 1 717 348 B1**
(45) Date of publication and mention of the grant of the patent: **20.12.2017**
(21) Application number: 06445014.1
(22) Date of filing: 10.04.2006
(51) Int. Cl.: C23C 28/04, C23C 30/00

(54) **Coated cutting tool insert**
Beschichteter Schneideinsatz
Plaquette de coupe pour outil de coupe revetu

(30) Priority: 18.04.2005 SE 0500858
(43) Date of publication of application: 02.11.2006
(73) Proprietor: Sandvik Intellectual Property AB, 811 81 Sandviken (SE)
(72) Inventor: Björmander, Carl, 174 56 Sundbyberg (SE)
(74) Representative: Hansson, Hans Martin

(56) References cited:
- EP-A- 1 455 003
- EP-A1- 0 693 574
- EP-A1- 0 878 563
- JP-A- 11 152 570

## Description

The present invention relates to a coated cutting tool, suitable for chip forming machining of metals, and a method for producing the same. According to the present invention there is provided a reliable method for removing coating layers on selected faces of a cutting insert during coating post-treatment.

Modern high productivity chip forming machining of metals requires reliable tools with excellent wear properties. This is achieved by employing a cemented carbide tool body coated with a wear resistant coating, of single layer or multilayer type, most commonly comprising wear layers of TiC, TiN, TiCN and Al₂O₃. For depositing the different layers onto the cemented carbide body, CVD, PVD, or similar coating techniques are used.

EP-A-693574 describes how different parts of a tool are subject to different types of wear during a machining operation. Since the various coating layers have different abilities to withstand the different types of wear, it is suggested to have an outermost Al₂O₃ layer on the rake face, because of its ability to withstand diffusion type wear, and on the clearance side it is suggested to have an outermost MeCₓN_{y}O_{z} type layer, where Me is a metal selected from groups IVB, VB, VIB of the periodic table, because of its high resistance to flank wear. A top layer of TiCₓN_{y}O_{z} or, in particular, a goldish TiN, ZrN or HfN top layer also makes it easy to differentiate between a used and an unused cutting edge by the naked eye. Hence, the TiCₓN_{y}O_{z} layer is mechanically removed from either only the edge line or from both the rake face and the edge line to expose the Al₂O₃ layer. Normally this is done by a post-treatment such as blasting or brushing of the coated inserts.

During the post-treatment, it is important not to reduce the Al₂O₃ layer thickness along the edge line. The method must therefore be so gentle that only the top TiCₓN_{y}O_{z} layer is removed, leaving the Al₂O₃ at the edge line as untouched as possible. However, the described post-treatment method is unreliable as residues of TiCₓN_{y}O_{z} occasionally appear on the Al₂O₃ surface after blasting process. TiCₓN_{y}O_{z} residues on the Al₂O₃ surface reduce the flaking resistance, due to welding of TiCₓN_{y}O_{z} to the work piece at the cutting edge resulting in coating withdrawal and a lower lifetime of the insert. A second effect of these residues after blasting is the discoloration, visible to the naked eye, of the Al₂O₃ surface. In production, blasting is usually repeated or modified in order to remove residual TiCₓNyO_{z}, but this often results in damage, such as flaking of the coating at the cutting edge line. It is therefore important to find a solution to this problem, especially for thin Al₂O₃ coatings, where usually lower blasting pressures are used in order not to damage the coating at the cutting edge, thus being subject to a higher risk of having TiCₓN_{y}O_{z} residues after the blasting process.

In patent US 6,426,137, a titanium oxide layer is utilized in order to reduce smearing onto the cutting edge. In this case the titanium oxide layer is fully covering the Al₂O₃ surface, acting as the top layer with a thickness of 0.1-3 µm. In another embodiment the titanium oxide layer is coated with a TiN layer.

It is an object of the present invention to solve the problem of residual TiCₓN_{y}O_{z} on the post-treated edge line and rake face.

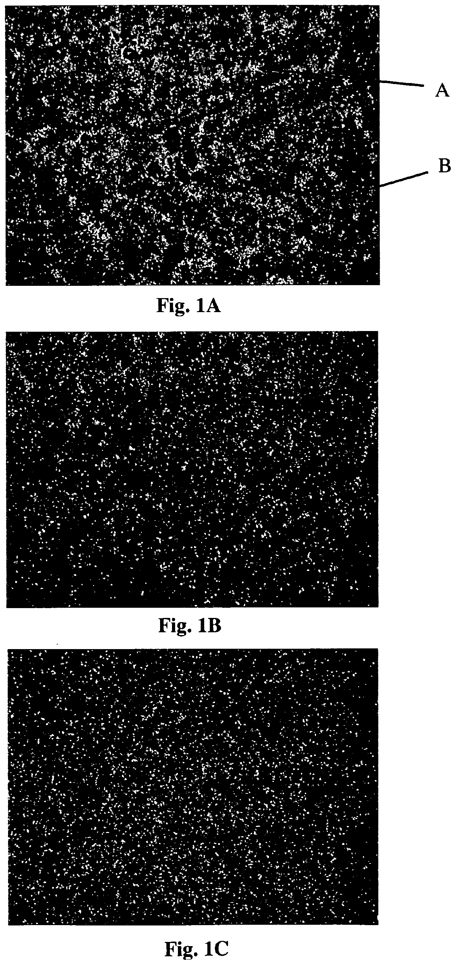

Figs. 1A-1C are light microscope micrographs showing in 200X, the outermost Al₂O₃ layer of inserts according to the present invention, with various amounts of titanium nitride residues after the blasting process, in which in Fig. 1A
A - TiN residues, and
B - Al₂O₃.

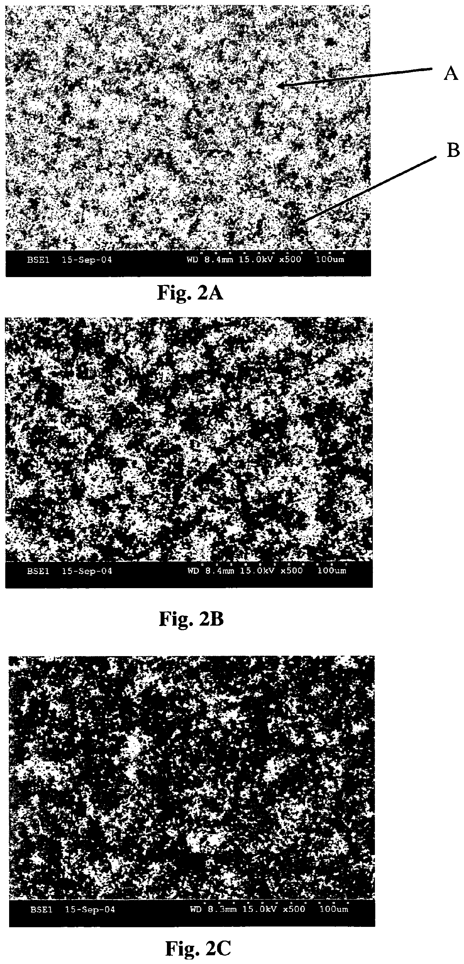

Figs. 2A-2C are scanning electron microscope micrographs showing in 500X, the outermost Al₂O₃ layer of inserts according to the present invention, with various amounts of titanium oxide residues after the blasting process, in which in Fig. 2A
A - Ti₂O₃ residues, and
B - Al₂O₃.

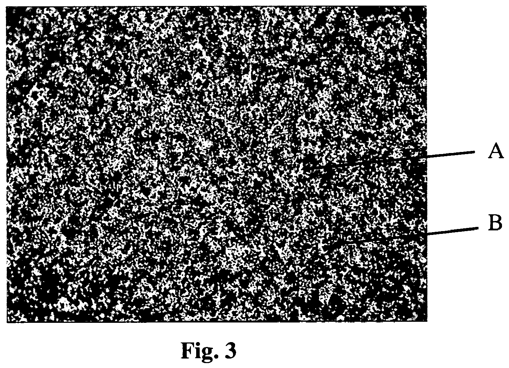

Fig. 3 is a light microscope micrograph showing in 200X, the outermost Al₂O₃ layer of an insert edge according to the prior art, with titanium nitride residues after the blasting process, in which
A - TiN residues, and
B - Al₂O₃.

According to the present invention there is now provided a method of making a coated cutting tool insert, having an upper face (rake face), an opposite face and at least one clearance face intersecting said upper and opposite faces to define cutting edges, comprising depositing onto a cemented carbide, titanium based or ceramic substrate, using known CVD methods
- a hard layer system, having a total thickness of 2-50 µm, comprising least one layer selected from titanium carbide, titanium nitride, titanium carbonitride, titanium carboxide and aluminum oxide, and an outer, 1-15 µm thick, aluminum oxide layer or (Al₂O₃ + ZrO₂) *N multilayer,
- a penultimate outermost layer of TiOₓ, where x ranges from 1 to 2, preferably from 1.3 to 1.9, having a thickness of 0.05-3 µm, most preferably 0.1-1.0 µm, and
- an outermost, 0.3-2 µm thick, TiCₓN_{y}O_{z} layer, where x+y+z=1, x≥0, y≥0, and z≥0, preferably a single layer or
multilayer of TiN, TiC or TiCₓN_{y}, where x+y=1, x≥0 and y≥0, followed by a post-treatment, preferably blasting or brushing, removing at least said outermost layer on the edge-line and on the rake face. To ensure the performance of the insert and the absence of any discoloration due to TiN residues, it is preferred that said post-treatment also removes at least 50 % of the TiOₓ layer, in terms of surface coverage, i.e., preferably at least 50 % of the outer layer surface of said hard layer system is exposed.

Using TiOₓ, which has a hardness of about 20% of that of Al₂O₃, with the proposed thickness, the TiCₓN_{y}O_{z} layer is thus lifted up above the rough Al₂O₃ surface, so that it can be fully removed by the blasting media. TiOₓ is furthermore a transparent oxide, which means that any residues left on the Al₂O₃ surface are not visible to the naked eye, as is the case with, e.g., TiN.

The present invention also relates to a coated cutting tool insert having an upper face (rake face), an opposite face and at least one clearance face intersecting said upper and opposite faces to define cutting edges made of cemented carbide, titanium based carbonitride or ceramics. The insert is coated with a hard layer system, having a total thickness of 2-50 µm, comprising at least one layer selected from titanium carbide, titanium nitride, titanium carbonitride, titanium carboxide and aluminum oxide, and an outer, 1-15 µm thick, aluminum oxide, preferably fine grained of a grain size of 0.5 to 3 µm α-Al₂O₃, layer or (Al₂O₃ + ZrO₂)*N multilayer, said hard layer system is provided with a TiOₓ layer, where x ranges from 1 to 2, preferably from 1.3 to 1.9, with a thickness of 0.05-3 µm, most preferably 0.1-1.0 µm, said TiOₓ layer being the outermost layer on the cutting edge line and rake face, and said TiOₓ layer is on the clearance side provided with an outermost, 0.3-2 µm thick, TiCₓN_{y}O_{z} layer, where x+y+z=1, x≥0, y≥0, and z≥0, preferably a single layer or multilayer of TiN, TiC or TiCₓN_{y}, where x+y=1, x≥0 and y≥0.

The grain size of the Al₂O₃ layer is determined from a SEM top view micrograph at 5,000 X magnification of the as deposited Al₂O₃ layer surface. Drawing three straight lines in random directions, the average distance between grain boundaries along the lines are taken as a measure of the grain size.

In a preferred embodiment said TiOₓ layer on the edge-line and rake face covers less than 50 % of the surface of said hard layer system.

### Example 1

A (invention): Cemented carbide cutting inserts CNMG 120408-PM with the composition 5.5 wt-% Co, 8.6 wt-% cubic carbides (TiC+TaC+NbC) and balance WC were coated with CVD-technique according to the following sequence: 0.7 µm TiN, 4.0 µm Ti(CN), 5.0 µm α-Al₂O₃, 0.7 µm titanium oxide (Ti₂O₃) and 0.7 µm TiN.

The Ti₂O₃ layer was deposited by CVD technique, where the substrates to be coated were held at a temperature of 1010 °C and were brought in contact with a hydrogen carrier gas containing TiCl₄, CO₂ and HCl. The nucleation was started up in a sequence where the reactant gases HCl and CO₂ entered the reactor first, in an H₂ atmosphere, followed by the TiCl₄. The titanium oxide layer was deposited with a CVD process with the following process parameters:

| Gasflows (in %). T=1010 °C, P=55 mbar. | Ti₂O₃ |
|---|---|
| H₂ (%) | 88.0 |
| HCl (%) | 7.6 |
| CO₂ (%) | 2.1 |
| TiCl₄ (%) | 2.3 |
| Deposition Rate (µm/hrs) | 1.5 |

The other layers where deposited by known CVD methods.

The coated inserts were post-treated by blasting at the different blasting pressures 1.8, 2.0 and 2.2 bar, using Al₂O₃ grits.

B (prior art): Cemented carbide cutting inserts CNMG 120408-PM with the composition 5.5 wt-% Co, 8.6 wt-% cubic carbides (TiC+TaC+NbC) and balance WC were coated with CVD-technique according to the following sequence: 0.7 µm TiN, 4.0 µm Ti(CN), 5.0 µm α-Al₂O₃ and 0.7 µm TiN by known CVD methods.

The coated inserts were post treated by blasting at 2.4 bar by using Al₂O₃ grits.

Inserts of type A and B were studied in a light microscope (200X) to detect any TiN residues on the Al₂O₃ surface and further in a scanning electron microscope (500X) to detect residues of Ti₂O₃. The amount of residual Ti₂O₃ was determined using image analysis (Leica Quantimet 500). The results are summarized in the following table.

| | | |
|---|---|---|
| Sample A, blasting at 1.8 bar (invention) | Some amount of TiN residues on the Al₂O₃-surface as observed by light microscope (Fig. 1A). Insert surface appear lightly discolored to the naked eye. | <75 % of Al₂O₃-surface covered by residual Ti₂O₃ (Fig. 2A). |
| Sample A, blasting at 2.0 bar (invention) | <1 % of Al₂O₃-surface covered by residual TiN (Fig. 1B). No discoloration of the insert surface. | <50 % of Al₂O₃-surface covered by residual Ti₂O₃. (Fig. 2B) |
| Sample A, blasting at 2.2 bar, (invention) | No residues of TiN (Fig. 1C). No discoloration of the insert surface. | <30 % of Al₂O₃-surface covered by residual Ti₂O₃. (Fig. 2C) |
| Sample B, blasting at 2.4 bar (prior art) | Large amount of TiN residues on the Al₂O₃-surface as observed by light microscope (Fig. 2). Insert surface appear discolored to the naked eye. | - |

## Claims

1. A method for making a coated cutting tool insert having an upper face (rake face), an opposite face and at least one clearance face intersecting said upper and opposite faces to define cutting edges **characterized in** depositing by CVD, onto a cemented carbide, titanium based or ceramic substrate
- a hard layer system, having a total thickness of 2-50 µm, comprising at least one layer selected from titanium carbide, titanium nitride, titanium carbonitride, titanium carboxide and aluminum oxide, and an outer, 1-15 µm thick, aluminum oxide layer or (Al₂O₃ + ZrO₂) *N multilayer,
- a penultimate outermost layer of TiOₓ, where x ranges from 1 to 2, preferably from 1.3 to 1.9, and wherein the deposited TiOₓ layer thickness is 0.05-3 µm, and
- an outermost, 0.3-2 µm thick, TiCₓN_{y}O_{z} layer, where x+y+z=1, x≥0, y≥0, and z≥0, preferably a single layer or multilayer of TiN, TiC or TiCₓN_{y}, where x+y=1, x≥0 and y≥0,
followed by a post-treatment, preferably blasting or brushing, removing at least said outermost layer on the edge-line and on the rake face.

2. A method for making a coated cutting tool insert according to claim 1 **characterized in that** said post-treatment also removes at least 50 % of the TiOₓ layer, in terms of surface coverage.

3. A coated cutting tool insert having an upper face (rake face), an opposite face and at least one clearance face intersecting said upper and opposite faces to define cutting edges, made of cemented carbide, titanium based carbonitride or ceramics, **characterized in** being coated with a hard layer system, having a total thickness of 2-50 µm, comprising at least one layer selected from titanium carbide, titanium nitride, titanium carbonitride, titanium carboxide and aluminum oxide, and an outer, 1-15 µm thick, aluminum oxide, preferably fine grained α-Al₂O₃, layer or (Al₂O₃ + ZrO₂) *N multilayer, said hard layer system is provided with a TiOₓ layer, where x ranges from 1 to 2, with a thickness of 0.05-3 µm, said TiOₓ layer being the outermost layer on the cutting edge line and rake face, and said TiOₓ layer is on the clearance side provided with an outermost, 0.3-2 µm thick, TiCₓN_{y}O_{z} layer, where x+y+z=1, x≥0, y≥0, and z≥0, preferably a single layer or multilayer of TiN, TiC or TiCₓN_{y}, where x+y=1, x≥0 and y≥0.

4. A cutting tool insert according to claim 3 **characterized in that** said TiOₓ layer on the edge-line and rake face covers less than 50 % of the surface of said hard layer system.

## Patentansprüche

1. Verfahren zum Herstellen eines beschichteten Schneidwerkzeugeinsatzes, der eine obere Fläche (Spanfläche), eine entgegengesetzte Fläche und zumindest eine Freifläche hat, welche die obere und die entgegengesetzte Fläche schneidet, sodass Schneidkanten definiert werden, **gekennzeichnet durch** CVD-Abscheidung auf einem Substrat aus Sintercarbid, auf Titanbasis oder aus Keramik
- eines Hartschichtsystem, welches eine Gesamtdicke von 2 bis 50 µm hat, und welche zumindest eine Schicht aufweist, die ausgewählt ist aus Titancarbid, Titannitrid, Titancarbonitrid, Titancarbonoxid und Aluminiumoxid, und eine äußere, 1 bis 15 µm dicke Aluminiumoxidschicht oder eine Mehrfachschicht aus (Al₂O₃ + ZrO₂) *N,
- einer vorletzten äußeren Schicht aus TiOₓ, wobei x im Bereich von 1 bis 2, vorzugsweise von 1,3 bis 1,9 liegt, und wobei die abgeschiedene TiOₓ-Schichtdicke 0,05 bis 3 µm beträgt, und
- einer am weitesten außen liegenden, 0,3 bis 2 µm dicken TiCₓN_{y}O_{z}-Schicht, wobei x+y+z=1, x≥0, y≥0 und z≥0, vorzugsweise eine Einzelschicht oder Mehrfachschicht aus TiN, TiC oder TiCₓN_{y}, wobei x+y=1, x≥0 und y≥0,
gefolgt von einer Nachbehandlung, vorzugsweise durch Strahlen oder Bürsten, mit Entfernen der zumindest am weitesten außen liegenden Schicht auf der Kantenlinie und auf der Spanfläche.

2. Verfahren zum Herstellen eines beschichteten Schneidwerkzeugeinsatzes nach Anspruch 1, **dadurch gekennzeichnet, dass** in der Nachbehandlung auch zumindest 50% der TiOₓ-Schicht entfernt werden, bezogen auf die Flächenabdeckung.

3. Beschichteter Schneidwerkzeugeinsatz mit einer oberen Fläche (Spanfläche), einer entgegengesetzt liegenden Fläche und zumindest einer Freifläche, welche die obere und die entgegengesetzte Fläche schneidet, sodass Schneidkanten definiert werden, hergestellt aus Sintercarbid, Carbonitrid auf Titanbasis oder Keramik, **gekennzeichnet dadurch, dass** er mit einem Hartschichtsystem beschichtet ist, das eine Gesamtdicke von 2 bis 50 µm hat, und zumindest eine Schicht aufweist, die ausgewählt wurde aus Titancarbid, Titannitrid, Titancarbonitrid, Titancarbonoxid und Aluminiumoxid, und mit einer äußeren, 1 bis 15 µm dicken Aluminiumoxidschicht, vorzugsweise aus feinkörnigem α-Al₂O₃, oder einer (Al₂O₃ + ZrO₂) *N-Mehrfachschicht, wobei das Hartschichtsystem mit einer TiOₓ-Schicht versehen ist, wobei x im Bereich von 1 bis 2 liegt, mit einer Dicke von 0,05 bis 3 µm, wobei die TiOₓ-Schicht die am weitesten außen liegende Schicht auf der Schneidkantenlinie und der Spanfläche ist, und wobei die TiOₓ-Schicht auf der Freifläche mit einer am weitesten außen liegenden, 0,3 bis 2 µm dicken TiCₓN_{y}O_{z}-Schicht versehen ist, wobei x+y+z=1, x≥0, y≥0 und z≥0, vorzugsweise mit einer Einzelschicht oder Mehrfachschicht aus TiN, TiC oder TiCₓN_{y}, wobei x+y=1, x≥0 und y≥0.

4. Schneidwerkzeugeinsatz nach Anspruch 3, **dadurch gekennzeichnet, dass** die TiOₓ-Schicht auf der Kantenlinie und der Spanfläche weniger als 50% der Oberfläche des Hartschichtsystems bedeckt.

## Revendications

1. Procédé de fabrication d'une plaquette d'outil de coupe revêtue présentant une face supérieure (face d'attaque), une face opposée et au moins une face de dépouille croisant lesdites faces supérieure et opposée de sorte à définir des arêtes tranchantes, **caractérisé par** le fait de déposer par CVD, sur un substrat en carbure cémenté, à base de titane ou céramique
- un système de couches dures, présentant une épaisseur totale comprise entre 2 et 50 µm, comprenant au moins une couche sélectionnée parmi le carbure de titane, le nitrure de titane, le carbonitrure de titane, le carboxyde de titane et l'oxyde d'aluminium, et une couche extérieure d'oxyde d'aluminium ou une multicouche extérieure de (Al₂O₃ + ZrO₂)*N, de 1 à 15 µm d'épaisseur,
- une couche, qui est la deuxième couche la plus à l'extérieur, de TiOₓ, où x est compris entre 1 et 2, de préférence entre 1,3 et 1,9, et où l'épaisseur de la couche de TiOₓ déposée est comprise entre 0,05 et 3 µm, et
- une couche, qui est la couche la plus à l'extérieur, de TiCₓN_{y}O_{z} de 0,3 à 2 µm d'épaisseur, où x + y + z = 1, x ≥ 0, y ≥ 0, et z ≥ 0, de préférence une unique couche ou une multicouche de TiN, de TiC ou de TiCₓN_{y}, où x + y = 1, x ≥ 0 et y ≥ 0,
suivi d'un post-traitement, de préférence un sablage ou un brossage, éliminant au moins ladite couche la plus à l'extérieur sur la ligne d'arête et sur la face de d'attaque.

2. Procédé de fabrication d'une plaquette d'outil de coupe revêtue selon la revendication 1, **caractérisé en ce que** ledit post-traitement élimine également au moins 50 % de la couche de TiOₓ, en termes de recouvrement de surface.

3. Plaquette d'outil de coupe revêtue présentant une face supérieure (face d'attaque), une face opposée et au moins une face de dépouille croisant lesdites faces supérieure et opposée de sorte à définir des arêtes tranchantes, constituée de carbure cémenté, de carbonitrure à base de titane ou de céramique, **caractérisée par** le fait d'être revêtue d'un système de couches dures, présentant une épaisseur totale comprise entre 2 et 50 µm, comprenant au moins une couche sélectionnée parmi le carbure de titane, le nitrure de titane, le carbonitrure de titane, le carboxyde de titane et l'oxyde d'aluminium, et une couche extérieure d'oxyde d'aluminium, de préférence d'α-Al₂O₃ de granulométrie fine ou une multicouche extérieure de (Al₂O₃ + ZrO₂)*N, de 1 à 15 µm d'épaisseur, ledit système de couches dures est doté d'une couche de TiOₓ, où x est compris entre 1 et 2, d'une épaisseur comprise entre 0,05 et 3 µm, ladite couche de TiOₓ étant la couche la plus à l'extérieur sur la ligne d'arête tranchante et la face d'attaque, et ladite couche de TiOₓ est dotée sur le côté de dépouille, d'une couche la plus à l'extérieur de TiCₓN_{y}O_{z}, de 0,3 à 2 µm d'épaisseur, où x + y + z = 1, x ≥ 0, y ≥ 0, et z ≥ 0, de préférence une unique couche ou une multicouche de TiN, de TiC ou de TiCₓN_{y}, où x + y = 1, x ≥ 0 et y ≥ 0.

4. Plaquette d'outil de coupe selon la revendication 3, **caractérisée en ce que** ladite couche de TiOₓ sur la ligne d'arête et la face d'attaque recouvre moins de 50 % de la surface dudit système de couches dures.
